# EUROPEAN PATENT APPLICATION

(11) **EP 4 647 186 A1**
(43) Date of publication of application: **12.11.2025**
(21) Application number: 24175062.9
(22) Date of filing: 09.05.2024
(51) Int. Cl.: B09B 3/40, B29B 17/02, H01L 31/048, B32B 17/10, B09B 101/15, B29K 23/00

(54) **SOLAR PANEL RECYCLING PROCESS AND APPARATUS**

(71) Applicant: Ecomade Engineering Srl, 35042 Este (PD) (IT)
(72) Inventor: FORMAGGIO, Daniele, 35042 Este (PD) (IT)
(74) Representative: De Giorgi, Michele

(57) **Abstract**

A process for recycling a solar panel (10), and apparatus which carries it out, wherein the solar panel (10) has an operating layer (15) to which a contaminating encapsulating element (13) is adhesively bonded.

The recycling process comprises a step A which provides for subjecting the solar panel (10) to a thermal processing operation which provides for heating the solar panel (10) to a processing temperature for such a processing time that the encapsulating element (13) reaches such a softening state as to be able to be delaminated from the operating layer (15).

## Description

The present invention relates to recycling solar panels.

The present invention is particularly directed towards a process and an apparatus for recycling a solar panel, preferably a photovoltaic panel.

The increase in the world population and the dependence on electrical energy in order now to carry out the majority of activities, like the increasing and contingent problems linked with pollution, have not only brought about the net increase of energy consumption but also the need to use a "clean" energy, that is to say, with a minimal impact on the environment.

In this socio-economic overview, there has now firmly been found a place of honour for the production of electricity by means of photovoltaic panels which are economic even in terms of maintenance and which are increasingly used both to form part of the anthropic environmental scheme of citizens, and not only this.

As a result of the increasing installation of photovoltaic panels and the consequent generation of a considerable volume of joined photovoltaic panels at the end of their lifetime, however, there is powerfully perceived a need to adopt adequate disposal solutions which allow the valuable materials which are present in the structure of the photovoltaic panels to be recycled and the residual material to be eliminated safely.

In fact, achieving a high level of recycling of the photovoltaic panels is perceived to be indispensable in order to avoid an inefficient waste of precious materials and to reduce the total demand for production of new panels which requires the extraction in great quantities of such precious materials, thereby pursuing the ultimate objective for which these panels exist, that is to say, minimizing emissions.

In particular, such precious or high-value materials which are used in the photovoltaic panels and which can be recovered comprise elements which are not widely available on our planet nowadays, such as copper (Cu), silver (Ag), tin (Sn) and lead (Pb) which are present in the connectors and silicon (Si) which is present in the cells in addition to some more common ones, such as aluminium (Al) and glass present in the structure of the panel, which are similarly re-usable.

In order to particularly recover the high-value materials, in recent years there have been tried different processes for recovering and recycling photovoltaic waste. However, many such recycling systems have not yet been implemented at an industrial level and, as a result of the increasing flow of this type of waste, the need for adequate management is becoming urgent. Furthermore, disposal without any recycling of the photovoltaic panels involves risks to the environment and health as a result of the release of toxic elements, such as lead and tin (which are used in the metal contacts and in the bars), the waste of recyclable materials (glass, Al, Si, Cu, etc.) and the depletion of precious metals such as silver.

In order to develop a technology which is sustainable from the point of view of economics and the environment for industrializing a process for recovering the photovoltaic waste, it is necessary to examine first of all the composition of the layers which constitute the structure of the panels.

Notwithstanding the fact that there have been tried various photovoltaic technologies, at a global level the silicon crystalline modules represent the photovoltaic technology which is most well-established and, therefore, the majority of the photovoltaic waste results from this type of module. These photovoltaic panels re constituted by an aluminium frame which surrounds a multi-layered panel which comprises:
- a first protective layer which is constituted by tempered glass, which is optically transparent and which withstands impacts and imparts mechanical strength and hardness to the panel;
- an operating layer of photovoltaic cells based on silicon;
- a second protective layer which is generally constituted by a film (for example, with a thickness of 0.35 mm) made of polymer material based on polyvinyl fluoride (PVF) and/or polyvinylidene fluoride (PVDF) and/or polyethylene terephthalate (PET) which is commercially known as Tedlar^{®};
- an encapsulating element which is constituted by EVA (ethylene vinyl acetate) which forms a plastics film and which is suitable for joining the first protective layer and the second protective layer, respectively, to a front face and to a rear face of the operating layer;
- another layer of EVA is used to encapsulate the photovoltaic panels, joining the rear face of the operating layer to the front face of the second protective layer.

There is connected to the rear of the multi-layered plate a junction box for the electrical connections which are electrically connected between the cells and between the cell modules and to a circuit which is suitable for receiving the energy which is generated by the panel and which generally comprises at least one printed circuit board (PCB) which are constituted by metal conductors, such as Ag and Cu.

These printed circuit boards (PCB) which are used in the junction box and in other electronic components of the photovoltaic panels are typically constructed by depositing metal traces - usually of the conductive metals mentioned - on organic substrates, such as epoxy resins or other polymers, which provide structural support and electrical insulation.

There are also provided electrical connectors which are suitable for electrically connecting the photovoltaic cells inside a module and the modules themselves inside a photovoltaic plant. These connectors can be, for example, copper wires which are covered in tin.

Furthermore, there are also provided welds which physically and electrically connect components such as the photovoltaic cells to each other, the bypass diodes and the panel output terminals. Generally, the welds comprise thin strips of metal (webs) based on alloys of tin and lead. There can also be added bismuth (Bi) for lowering the melting point and antimony (Sb) for improving the mechanical strength of the weld.

Nowadays, there are known to the inventor the processes for disposing of the photovoltaic waste which are distinguished as mechanical processes (shredding) and thermal processes.

The mechanical process involves the total grinding of the panels and the confinement thereof in landfill.

This process does not allow the recovery of the high-value materials which are present in the structure and recently it has been increasingly avoided and opposed.

The thermal process involves high-temperature processing before mechanical removal of the frame made of aluminium. In particular, this known process is carried out at high temperatures which are intended to chemically decompose the polymer component which is present in the panels in order to continue with a delamination of the various layers and the recovery thereof. Conventionally, this thermal process is followed by pyro-metallurgical processes or - less widely - hydro-metallurgical processes which are intended to extract the conductive metals which are present in the electrical components and electronics of the solar panels in a pure form.

The temperatures of the known thermal process necessarily have to be no less than 550°C in order to ensure total degradation of the EVA and thereby to completely recover the high-value materials which are present in the photovoltaic panels.

Generally, this known thermal process provides for the use of a thermal processing for degrading the polymer component at temperatures between 550°C and 650°C. Therefore, a disadvantage which is powerfully perceived of this conventional process is the high energy cost of the management.

In this context, the Applicant has observed that the most critical phase of the current recovery processes is the removal of the polymers and separation of the different layered materials.

In particular, the Applicant has observed that the layer which most inhibits ease of recycling of the various layers of the photovoltaic panels is the layer which is constituted by EVA.

In fact, this material constitutes the capsule which encloses the cell and the weld to the glass of the first layer. It is used in the production of the photovoltaic panels, being a low-cost material with good adhesion, good chemical and physical characteristics for solar silicon. Usually, for the encapsulation there is used a thin transparent film (0.5 mm) of polymer material so as to maintain better optical transmission (approximately 90%) in the optimum spectral region for the operation of the solar panels. The EVA encapsulations further protect the solar panels from cracks resulting from excessive loads, form an electrical insulation and protect the cells from humidity and other environmental effects.

Although the above-described, known thermal process at high temperatures allows the total degradation of the EVA and thereby the complete recovery of the high-value materials present in the photovoltaic panels, it is not greatly appreciated in view of the high levels of energy consumption which the implementation thereof involves.

Furthermore, the Applicant has found that the thermal decomposition of the polymer component of the photovoltaic panels leads to the formation of dangerous by-products, such as a number of toxic and/or corrosive gases (such as, for example, hydrocarbons) which have a negative impact on the ozone layer and on the greenhouse effect, and on health.

In fact, the above-mentioned thermal process requires processing of the fumes resulting from the processing of the panels which is substantially onerous in terms of energy and filtration and cleaning.

The toxic substances which are produced by the implementation of this known thermal process require special systems for processing the gases and introduce serious technological difficulties into the planning and the management of the plants which are used for carrying out this process.

For those reasons, the Applicant has perceived the need to provide a process for recovering the materials forming the photovoltaic panels which is reasonably economical, scalable to an industrial level and minimizes the production of toxic fumes.

The Applicant has further found that the pyro-metallurgical processes which are conventionally used for recovering the high-value conductive metals which are present in the electrical/electronic components of the photovoltaic panels, although being very effective, require very high temperatures, often greater than 1000°C, in order to melt the materials and to promote the chemical reactions which are necessary to recover them in a pure form.

Furthermore, in the conventional pyro-metallurgical processes there is a need to separate the conductive metals from the polymer substrate before carrying out the high-temperature processing which is suitable for melting the metals in order to recover them.

Therefore, although the pyro-metallurgical techniques are effective in recovering the metals, they also have challenges, in particular in terms of environmental impact as a result of the high emissions of CO₂ and the energy consumption.

For this reason, the Applicant has perceived the importance of developing more efficient processes from the point of view of energy, which are intended to make the recycling of the metals present in the solar panels - and not only those items - more sustainable.

In this regard, the Applicant has noted that, by following the thermal process for recycling the photovoltaic panels with a pyro-gasification process for recovering the conductive metals which are contained in the electrical/electronic components of these photovoltaic panels, this allows a reduction in the total costs and a reduction in the emissions of carbon anhydride which correlate with the conventional pyro-metallurgical processes.

In particular, the Applicant has determined the advantage of the pyro-gasification because of a thermo-chemical process which differs from the conventional pyro-metallurgical methods mainly as a result of the approach thereof to the management of the organic materials.

Furthermore, while it is necessary in the conventional processes to separate beforehand the metal component from the polymer component, in the pyro-gasification this operation is not necessary. While the pyro-metallurgical methods concentrate on melting and refining the metals at high temperatures, the pyro-gasification is carried out at lower temperatures which are sufficient to decompose (in the absence of oxygen) the organic materials which give rise to a mix of combustible gases, such as hydrogen and methane, which are collectively known as "syn-gases" or synthesis gases, which can then be used as an energy source for the process itself or as a raw material for producing other chemical products, adding an additional value to the process.

Therefore, the Applicant has observed that, by using a pyro-gasification process for recovering the conductive metals from the electrical/electronic components of the photovoltaic panels, it is possible to allow use of the heat which is released - precisely - from the decomposition of the organic materials in the absence of oxygen (or under conditions with limited oxygen) in order to support the melting and recovery of these metals at temperatures which are lower than those in the conventional pyro-metallurgical processes. This process further also reduces the volume of the materials which are processed and allows metals to be recovered from the organic substrates.

Therefore, the Applicant has found that, in the presence of printed circuit boards (PCB) which contain both precious metals (such as silver and copper) and organic polymer substrates (such as epoxy resins), not exclusively in the context of photovoltaic panels but also in general, the pyro-gasification provides a potentially effective method for separating and recovering the metals, at the same time eliminating the organic materials by converting them to combustible gases.

For these reasons, therefore, the Applicant has perceived a need to provide a process for recovering the materials forming the photovoltaic panels which includes a step of pyro-gasification of the electrical/electronic components which includes the PCBs - therefore, comprising organic polymer materials - which allows a reduction in the costs of recovery of the conductive metals which are present in the photovoltaic panels but which is effective at the same time.

In the context of the present description, a number of definitions have the meaning indicated below.

The term "softening" is intended to be understood to be a physical chemical state of the encapsulating element such that it can be removed substantially integrally, as a separate member, from the operating layer. The term "substantially integrally" is intended to be understood to mean that the separation is such as not to leave on the operating layer any residues of the material which constitutes the encapsulating element so as to bring about a contamination of the operating layer with resultant incompatibility with extraction of the elements or materials which constitute the operating layer itself in order to obtain efficient recycling thereof.

The term "with a low oxygen content" or "with a limited oxygen content" is intended to be understood to refer to conditions in which the oxygen is present in limited quantities which are sufficiently low to prevent the complete combustion of the materials but high enough to support specific chemical reactions which do not require the entire quantity of oxygen normally necessary for total combustion. The quantification of the oxygen may vary substantially on the basis of the material to which the process relates; for the pyro-gasification of the PCBs which are contained in the photovoltaic panels, this is a percentage of oxygen in the reactive environment of from 1 to 2% or less. This quantity is sufficient to support the conversion reactions of the organic material without allowing complete combustion which would require far higher levels of oxygen.

Furthermore, in the context of the present invention, the PCBs in the junction box, connectors and welds can be defined below for simplicity as "electrical/electronic components".

The problem addressed by the present invention is to at least partially solve the problems set out in the prior art by means of a process which allows the recovery of the high-value materials which are contained in the solar panels, particularly in the photovoltaic panels with silicon crystals.

In the context of this object, an objective of the present invention is to provide a process for recycling the photovoltaic panels which is industrially scalable, potentially able to be automated and economical.

Another object of the present invention is to provide an apparatus which allows a process to be carried out for recycling photovoltaic panels which allows the recovery of the high-value materials which are contained in the photovoltaic panels and which is productive and effective.

This object and these objectives and other objectives which will become clearer below are achieved by a process and apparatus for recycling a solar panel according to the appended independent claims.

Detailed features of a process and apparatus for recycling a solar panel according to the present solution are set out in the dependent claims.

Additional features and advantages of the invention will be better appreciated from the description of a preferred though non-exclusive embodiment of a process and apparatus for recycling a solar panel according to the present solution, which is illustrated in an embodiment thereof which is illustrated by way of non-limiting example in the appended table of drawings, in which:
- Figure 1 is a simplified, exploded view of a solar panel, more specifically a photovoltaic panel based on crystalline silicon;
- Figure 2 is a schematic view of an apparatus for recycling a solar panel according to the present solution.

With particular reference to the cited Figures, there is generally designated 10 a solar panel and preferably a photovoltaic panel which may comprise a protective layer 12.

Preferably, the protective layer 12 is constituted by tempered glass, which is optically transparent and which withstands impacts and provides mechanical resistance for the panel over time.

The solar panel 10 in a manner known per se may comprise an operating layer 15 which has a front face 14 and which is configured to generate electrical energy following the incidence on the front face 14 of light radiation in a manner known per se.

Preferably, the operating layer 15 comprises photovoltaic cells based on silicon crystals.

The operating layer 15 further comprises a rear face 14b which is opposite the front face 14. Preferably, the protective layer 12 covers the front face 14 of the operating layer 15.

The solar panel 10 may comprise an encapsulating element 13.

There may be present between the protective layer 12 and the operating layer 15 at least one front portion 13a of the encapsulating element 13.

In particular, the encapsulating element 13 adhesively bonds at least to the front face 14 of the operating layer 15 in order to protect it.

In particular, the front portion 13a of the encapsulating element 13 adhesively bonds to the front face 14 of the operating layer 15.

The encapsulating element 13 may be based on ethylene vinyl acetate (EVA) or comprises EVA.

In fact, advantageously, ethylene vinyl acetate (EVA) is a copolymer which is composed of ethylene and vinyl acetate and which therefore has a structure which combines the resistance and resilience of the polyethylene with the flexibility and the adhesive properties of the vinyl acetate. In other words, the ethylene contained in the EVA confers mechanical resistance while the content of vinyl acetate improves the adhesive characteristics thereof.

The solar panel 10 may comprise a frame 11 which surrounds the operating layer 15 and the protective layer 12.

The frame 11 may be constituted by a metal material which particularly may be aluminium.

In a particularly preferred version of the solar panel 10, the encapsulating element 13 also adheres to the rear face 14b of the operating layer 15 in order to protect it.

In other words, the encapsulating element 13 can be constituted by a single member which covers at least the front face 14 of the operating layer 15 or which encapsulates the operating layer by covering both the faces 14 and 14b thereof, or the encapsulating element may be constituted by two sheets which cover at least the front face 14 and the rear face 14b of the operating layer 15.

Furthermore, the solar panel 10 may also comprise a rear protection layer 16 which covers the rear face 14b of the operating layer 15.

The rear layer 16 may be constituted or comprises a film (for example, with a thickness of 0.35 mm) based on polyvinyl fluoride (PVF) and/or polyvinylidene fluoride (PVDF) and/or polyethylene terephthalate (PET).

The solar panel 10 may also comprise a junction box 20 for the electrical connections which are suitable for electrically connecting the operating layer 15 to a circuit which is configured to receive the energy which is generated by the solar panel 10. Furthermore, there may be present a series of electrical/electronic components for connecting the cells to each other and the cell modules.

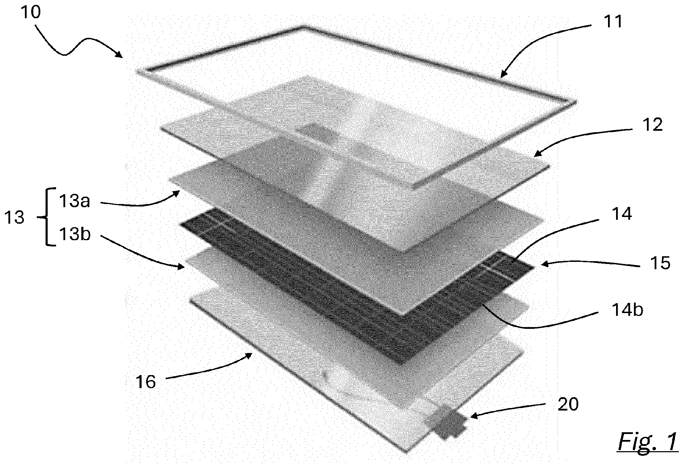

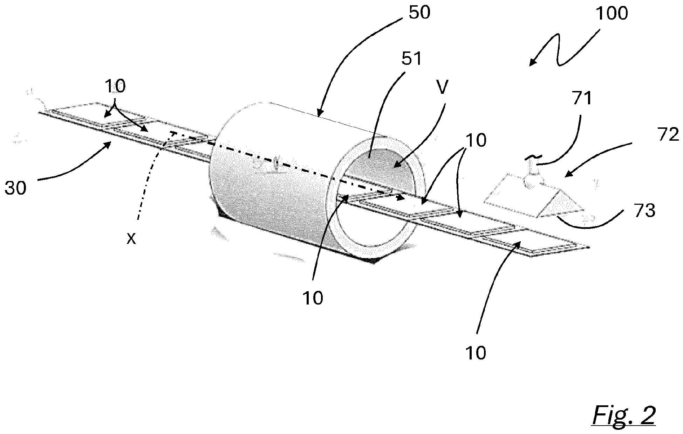

A recycling process for a solar panel according to the present solution may be applied to the recycling of a solar panel 10, for example, such as the one depicted in Figure 1, for example, by using an apparatus such as the one shown in Figure 2.

The process according to the present solution may comprise a step A which comprises subjecting the solar panel 10 to a thermal processing operation which provides for heating the solar panel 10 to a processing temperature for such a processing time that the encapsulating element 13 reaches such a softening state as to be able to be delaminated from the operating layer 15.

Thus, the protective layer 12, the operating layer 15, the optional rear layer 16 and the encapsulating element 13 can be mutually separated sequentially from each other without it being necessary to apply thereto a stress which may bring about a fracture or shattering thereof so as to cause mutual contamination thereof.

In other words, by means of a recycling process for a solar panel according to the present solution, it is possible to detach, for example, the protective layer 12 from the operating layer 15, separating the encapsulating element 13 therefrom so that it does not contaminate the recyclable materials, from which the protective layer 12 and the operating layer 15 are composed.

In particular, following the use of a recycling process for a solar panel according to the present solution, it will be possible to obtain the operating layer 15 which is separated from the protective layer 12 and the optional rear layer 16 so that each of them has no substantial contaminations of the material which constitutes the encapsulating element 13.

The Applicant has observed that the implementation of a recycling process for a solar panel 10 according to the present solution allows a great reduction in the consumption of energy necessary for forming the recyclable materials without any contamination, particularly EVA, with respect to the known thermal processing operations.

Furthermore, the Applicant has observed that the recycling process for a solar panel according to the present solution has a substantially reduced environmental impact because - with respect to the conventional thermal processing operations - the formation of gases and toxic volatile emissions is greatly reduced.

In fact, the Applicant has understood that the thermal processing at a predetermined processing temperature for a predetermined processing time allows the production of the structural modifications of the EVA so as to bring about the loss of adhesive capacity thereof without, however, causing the degradation thereof.

In particular, the Applicant has understood that the thermal processing operation according to the present solution allows the cross-linking points, that is to say, the bonding points, to be weakened between the chains of the two polymers along the structure of the copolymer and therefore allows promotion of a state of softening which simplifies the delamination of the encapsulating element 13 particularly from the operating layer 15.

The step A can be carried out in a recycling apparatus for solar panels which, for example, may be similar to the one depicted in Figure 2.

In particular, in Figure 2, there is generally designated 100 an apparatus for recycling a solar panel 10 according to the present solution.

The apparatus 100, in the main components thereof, may comprise:
- an optional transport unit 30,
- a thermal processing unit 50 and
- a delamination unit 70.

The thermal processing of the step A may be carried out in the thermal processing unit 50 such as the one of apparatus 100.

Accordingly, the thermal processing unit 50 may be configured to heat the solar panel 10 to a processing temperature for a processing time so that the encapsulating element 13 reaches such a softening state as to be delaminable from the operating layer 15.

For example, the thermal processing unit 50 may comprise:
- heating means, which are described in greater detail below and which are configured to transmit heat to the encapsulating element 13, for example, by heating the solar panel 10 by means of radiation and/or convection, which may be forced where applicable;
- movement means which are suitable for generating a mutual movement between the heating means and a solar panel 10 to be processed, in order to regulate the exposure time of the solar panel 10 to the heating means, that is to say, in order to regulate where applicable in coordination with regulation of the heating means, the thermal flow which the thermal processing unit 50 is provided to discharge to the encapsulating element.

The recycling apparatus may comprise a control device for the thermal processing unit 50 or it may be included therein and may be connected to the heating means and the movement means for controlling them.

In particular, the control device may be configured to automatically actuate the heating means and the movement means in accordance with specifications of an operator so that the encapsulating element 13 receives a quantity of heat suitable for bringing it into a softening condition without melting it or causing the combustion thereof.

For example, the thermal processing unit 50 may be or may comprise a heating tunnel 51 and the heating means may comprise radiant panels which are provided with heaters, for example, infrared heaters, preferably with ceramic insulation.

As shown in Figure 2, for example, a solar panel 10 is arranged on a sliding plane 31 of the transport unit 30 in order to be conveyed into the thermal processing unit 50, wherein it can be subjected to a thermal processing operation at a processing temperature for a processing time.

Preferably, the thermal processing unit 50 is configured so as to obtain a situation where the processing temperature is such as to heat the encapsulating element 13 so that it has a minimum temperature between 130°C and 170°C.

Advantageously, a minimum temperature between 130°C and 170°C is around the melting temperature of the encapsulating element 13.

In particular, a minimum temperature between 130°C and 170°C is around the melting temperature of EVA.

More preferably, the heating unit 50 is configured to obtain a situation in which the processing temperature is such as to heat the encapsulating element 13 so that it has a minimum temperature between 140°C and 160°C, and preferably of 144°C.

In fact, the Applicant has found that a minimum temperature between 140°C and 160°C, and preferably of 144°C, allows the provision of a state of incipient melting of the encapsulating element 13.

In particular, a minimum temperature between 140°C and 160°C, and preferably of 144°C, allows the provision of a state of incipient melting if the encapsulating element 13 is based on EVA or comprises EVA.

In fact, the Applicant has understood that this allows the polymer chains of the material constituting the encapsulating element 13 to obtain sufficient mobility so as to readily be detached from the adjacent layers, that is to say, from the operating layer 15 and the protective layer 12, without any loss of cohesion so as to bring about a fragmentation of the encapsulating element.

In other words, the encapsulating element 12 following the processing according to the present solution maintains sufficient integrity as to allow the simple and efficient separation of the protective layer 12, the operating layer 15 and the optional rear layer 16 from the encapsulating element 13 itself.

Again, in other words, a process and an apparatus for recycling according to the present solution allow it to be achieved that the encapsulating element 13 reaches a physical/chemical state such that it is simply able to be separated from additional components of the solar panel 10 with which it is in contact or to which it adheres.

In fact, the current Applicant has understood that the heating of the encapsulating element 13 to the processing temperature for the processing time reasonably allows a chemical/physical state of the encapsulating element 13 to be reached so that the cohesion force of the molecules of the material constituting the encapsulating element 13 is greater than the molecular adhesion force to the material which forms the protective layer 12 and/or the material which forms the operating layer 15 and/or the material which forms the optional rear layer 16. Furthermore, in this condition, the encapsulating element 13 is found to have such a deformability that - in combination with the molecular interaction state - the encapsulating element 13 is separable from the protective layer 12 and/or from the operating layer 15 and/or from the optional rear layer 16 without leaving substantial contaminating traces on them.

For example, in the processing unit 50 of the apparatus 100 a minimum temperature of 144°C can be imposed by means of the control device (not shown) which is connected to the heating tunnel 51.

In any manner, it is preferable for the recycling apparatus and particularly the thermal processing unit to be configured in such a manner that the processing temperature is such as to heat the encapsulating element 13 to a maximum temperature which is no greater than a chemical degradation temperature of the encapsulating element 13.

Advantageously, this avoids the encapsulating element 13 becoming degraded, leading to the formation of gaseous products which would require processing of the fumes and/or processing for reducing such products.

Furthermore, reaching the degradation temperatures, which are used in the conventional plants, has a significant energy burden and also requires more sophisticated apparatuses. Costly and sophisticated apparatuses are complex to scale industrially.

On the other hand, maintaining the thermal processing at lower temperatures than the degradation temperatures allows a reduction in the energy costs and allows simpler apparatuses to be provided both in terms of assembly and in terms of management.

The heating unit 50 is therefore configured in such a manner that, when the encapsulating element 13 is based on EVA, or comprises EVA, the processing temperature is substantially less than the degradation temperature of the EVA which is the deacetylation temperature of the EVA which may be between 300°C and 400°C.

Preferably, the heating unit 50 is configured to bring about a maximum processing temperature which is such that the encapsulating element 13 at the processing temperature has such a consistency as to be able to be handled together.

In other words, the maximum processing temperature is selected so as to allow the removal of the encapsulating element 13 substantially as a single member and thus to avoid possible residues remaining on the operating layer 15 which would otherwise have to be further processed before recovering the high-value materials contained therein.

Preferably, the processing time is between 30 seconds and 5 minutes and more preferably between 1 and 3 minutes.

This processing time allows an adequate softening state which enables the delamination of the encapsulating element 13 to be achieved.

Preferably, the recycling process for a solar panel 10 further comprises a step B in which the encapsulating element 13 is removed from the operating layer 15, sequentially carrying out sub-steps.

The step B can be carried out, for example, by the delamination unit 70 of the apparatus 100, as shown in Figure 2. In particular, preferably during the step B a sub-step B1 is initiated in which a first portion of the encapsulating element 15 is removed from the front face 14.

The first portion of the encapsulating element 13 is intended to be understood to be the majority of the encapsulating element 13 which covers at least the front face 14 of the operating layer 15 or also a first sheet which covers the front face 14 of the operating layer 15.

The first portion of the encapsulating element 13 is removed from the front face 14, preferably in the region of the delamination unit 70.

In particular, the first portion of the encapsulating element 13 may be removed by using robots which are present in the delamination unit 70.

These robots may be suitable for gripping the structure of the photovoltaic panel in order to make it easier to reach all the locations of the structure of the photovoltaic panel to be processed.

The first portion of the encapsulating element 13, for example, may be removed by scraping.

The scraping can be caried out by robots which are present in the delamination unit 70 and which are suitable for gripping the structure of the photovoltaic panel to be processed and to carry out thereon a scraping action of a portion of the encapsulating element 13.

Alternatively, the first portion of the encapsulating element 13, for example, by means of a stripping action, that is to say, by gripping a peripheral edge of the encapsulating element 13 and subsequent traction of this edge directed towards progressively detaching the encapsulating element 13 from the operating layer 15 by applying, for example, transverse traction force to the operating layer 15, that is to say, non-parallel therewith, which may be, for example, between 2.5 GPa and 5 GPa.

In this case, for example, the delamination unit may be provided with a set of pincers which is suitable for gripping a portion of the peripheral edge of the encapsulating element 13. After the sub-step B1, the step B may comprise a sub-step B2, in which the operating layer 15 is raised by means of interaction of a lifting device with the front face 14 in order to expose a rear face 14b of the operating layer 15 which is opposite the front face 14.

The delamination unit 70 of the apparatus 100 may in fact comprise a mechanical arm 71 which is connected to the apparatus 100 at one end thereof. At the opposite end, the mechanical arm 71 may terminate as a lifting means 72 which can be provided with suction cups 73 which apply a slight reduced pressure (for example, of from -40 to -60 kPa) to the front face 14 of the operating layer 15, raising it from the sliding plane 31 of the transport unit 30.

Preferably, after the sub-step B2, the step B comprises a sub-step B3, in which a second portion of the encapsulating element 15 which is preferably a residual portion with respect to the first portion, is removed from the rear face 14b, for example, by scraping. The encapsulating element 13 can in fact be constituted by a single member or by two sheets. When the encapsulating element is constituted by a single member, the residual portion can be constituted by residues of the single member removed. When the encapsulating element is constituted by two sheets, the residual portion may also comprise a second sheet of the encapsulating element.

Advantageously, the step B of the recycling process may be carried out in a delamination unit 70 which has a thermal containment structure.

That is to say, the delamination unit 70 may be configured in the region of a structure which is suitable for opposing a dispersion of thermal energy by the panel 10 which is transmitted thereto by the processing unit 50.

For example, the delamination unit 70 may comprise a thermal containment structure with an elongate cap or, in other words, barrel-like vault which is made from materials with thermal insulation properties.

The thermal containment structure of the delamination unit 70 may be adjacent to or be an extension of the processing unit 50, or integral therewith, and, for example, of the heating tunnel 51.

In this manner, it will be possible to use the thermal inertia of the heat which is produced in the processing unit 50, this heat being produced, for example, by radiant panels.

Advantageously, the step B of the recycling process for a solar panel 10 allows the removal of the encapsulating element 13 from the operating layer 15, avoiding the degradation thereof and the resultant production of degradation by-products.

Advantageously, the thermal processing at the processing temperature for the processing time allows promotion of a softening state of the encapsulating element 15 which simplifies the implementation of the step B.

When the panel 10 comprises the protective layer 12 which covers the front face of the operating layer 15 and there is present between the protective layer 12 and the operating layer 15 at least one portion 13a of the encapsulating element 13, the recycling process comprises a step C in which the protective layer 12 is removed from the operating layer 15 and preferably from the encapsulating element 13.

The step C also allows advantageous recovery of the protective layer 12 so that the materials which form it can be recycled, allowing the greatest quantity possible of material from the solar panel 10 to be recycled.

Preferably, the recycling process according to the present solution, preferably following the step C, provides for the encapsulating element 13 to be at a temperature at which it is in a softening state in order to be delaminable from the operating layer 15 or from the protective layer 12.

In this manner, the delamination of the encapsulating element 13 from the operating layer 15 or from the protective layer 12 will advantageously be facilitated.

When the solar panel 10 comprises the frame 11, the recycling process may comprise a step D, which is preferably before the step A, in which the frame 11 is removed, for example, mechanically, from the operating layer 15 and, if present, from the protective layer 12.

The step D may also allow recovery of the material(s) which form(s) the frame. In this manner, the recycling efficiency is maximized.

The recycling process according to the present solution may also provide for a step E of removing any residues of encapsulating element 13. The residues may be removed, for example, by processing with a gas flow, for example, a flow of nitrogen, of the operating layer 15 and/or the protective layer 12, if present. Alternatively again, there may be used a low-temperature fluid, for example, there may be used liquid nitrogen in the form of a spray so as to "freeze" the residues and at the same time to remove them by blowing. This allows final contaminations of the materials which form the operating layer 15 and the optional protective layer 12, which can be immediately re-used for additional processes, to be avoided.

Therefore, it will be understood how a process and an apparatus for recycling according to the present solution achieves the object and the objectives set out.

The invention configured in this manner is capable of a number of modifications and variants, all of which are included within the scope of teaching of the appended claims.

Furthermore, all the details may be replaced by other technically equivalent elements.

In practice, the materials used and the contingent forms and dimensions may be varied in accordance with the contingent requirements and the prior art.

Where the constructive features and the techniques mentioned in the present description and in the following claims are followed by reference signs or numerals, these reference signs or numerals have been placed with the sole objective of increasing the comprehensibility of the claims and the description themselves and, consequently, they do not constitute in any manner a limitation on the interpretation of each element identified, purely by way of example, by such reference signs or numerals.

At the end of these steps, the process according to the invention can provide for a step X of pyro-gasification. Initially, the electrical/electronic components are recovered from the structure of the panel and also from the junction box. In particular, for this, the junction box is opened, the plastics covering is discarded and there are recovered the internal electrical/electronic components.

Preferably, therefore, the electrical/electronic components are shattered into smaller pieces in order to increase the efficiency of the process.

These electrical/electronic components which are shredded are then heated in an environment with a low content of oxygen to a temperature approximately between 400°C and 800°C, more preferably between 550°C and 700°C, even more preferably to 600°C, so as to decompose the organic materials, for example, the materials of the substrates of the PCBs, such as epoxy resins, converting them into synthesis gas.

After the pyro-gasification, the residual material which contains the metals is cooled. This residual material may still comprise metals in solid form, alloys and metal compounds.

The residual material after the pyro-gasification may be solid. In fact, the metals contained in the electrical/electronic components of the photovoltaic panels are not necessarily in the molten state after the pyro-gasification because the temperature used is insufficient to melt all the types of metals present in the electrical/electronic components of the photovoltaic panels.

Subsequently, once the residual material from the pyro-gasification has cooled, the metals can be separated from other non-metal materials by means of mechanical processes or, more preferably, by washing with acid solutions in order to dissolve the metals, simplifying the separation thereof from the non-soluble materials.

Subsequently, the separation of the alloys and the recovery of the metals in pure form can be carried out with known techniques. The final purification techniques of the metals are similarly known. Preferably, this pyro-gasification step which is applied to the electrical/electronic components present in the photovoltaic panels - but not only them - allows conversion of the organic materials into useful gases, significantly reducing the volume of the solid waste.

This pyro-gasification step may further allow the passage of the separation of the organic components from the metal components to be skipped.

Furthermore, this pyro-gasification process, particularly applied to PCBs present in the photovoltaic panels, facilitates the separation and recovery of the metals from the organic substrates.

Additionally, the synthesis gas generated can be used to produce energy, thereby contributing to the energy efficiency of the process.

## Claims

1. A process for recycling a solar panel (10) which comprises:
- an operating layer (15) which has a front face (14) and which is configured to generate electrical energy following the incidence on the front face (14) of light radiation;
- an encapsulating element (13) which adheres at least to the front face (14) of the operating layer (15) in order to protect it;
wherein the recycling process comprises:
- step A which comprises subjecting the solar panel (10) to a thermal processing operation which provides for heating the solar panel (10) to a processing temperature for such a processing time that the encapsulating element (13) reaches such a softening state as to be able to be delaminated from the operating layer (15).

2. A process for recycling a solar panel (10) according to claim 1, wherein the processing temperature is such as to heat the encapsulating element (13) so that it has a minimum temperature between 130°C and 170°C.

3. A process for recycling a solar panel (10) according to the preceding claim, wherein the processing temperature is such as to heat the encapsulating element (13) so that it has a minimum temperature between 140°C and 160°C, and preferably of 144°C.

4. A process for recycling a solar panel (10) according to any one of the preceding claims, wherein the processing temperature is such as to heat the encapsulating element (13) to a maximum temperature which is no greater than a chemical degradation temperature of the encapsulating element (13).

5. A process according to the preceding claim, wherein the encapsulating element (13) is based on ethylene vinyl acetate, using the acronym EVA, or comprises EVA, and the degradation temperature comprises the deacetylation temperature of the EVA and is preferably between 300°C and 400°C.

6. A process according to any one of claims 4 and 5, wherein the maximum temperature is such that the encapsulating element (13) has such a consistency as to be able to be handled together.

7. A process for recycling a solar panel (10) according to any one of the preceding claims, wherein the processing time is between 0.5 and 5 minutes and preferably between 1 and 3 minutes.

8. A process for recycling according to any one of the preceding claims, which comprises a step B in which the encapsulating element (13) is removed from the operating layer (15) by sequentially carrying out:
- a sub-step B1 in which a first portion of the encapsulating element (13) is removed from the front face (14), preferably by scraping;
- a sub-step B2, in which the operating layer (15) is raised by means of interaction of a lifting device (72) with the front face (14) in order to expose a rear face (14b) of the operating layer (15) which is opposite the front face (14);
- a sub-step B3 in which a second portion of the encapsulating element (13), which is preferably a residual portion with respect to the first portion, is removed from the rear face (14b), for example, by scraping.

9. A process for recycling according to any one of the preceding claims, wherein the solar panel (10) comprises a protective layer which covers the front face (14) of the operating layer (15); there is present between the protective layer (12) and the operating layer (15) at least one portion of the encapsulating element (13); the recycling process comprises a step C in which the protective layer (12) is removed from the operating layer (15) and preferably from the encapsulating element (13); following the step C, the encapsulating element (13) being at a temperature at which it is in a softening state in order to be delaminable from the operating layer (15) or from the protective layer (12).

10. A process for recycling according to any one of the preceding claims, wherein the solar panel (10) comprises a frame (11) which surrounds the operating layer (15) and the protective layer (12), if present; the recycling process comprises a step D, which is before the step A, in which the frame (11) is removed, preferably mechanically, from the operating layer (15) and, if present, from the protective layer (12).

11. A process for recycling according to any one of the preceding claims, comprising a step F, after the step A, in which any polymer residues are removed from the operating layer (15) and the protective layer (12), if present, by means of a gas flow, preferably a flow of nitrogen.

12. An apparatus (100) for recycling a solar panel (10) which is configured to carry out a recycling process according to any one of the preceding claims, wherein the apparatus (100) comprises:
- a transport unit (30) which defines a processing direction (X) of the solar panel (10),
- a thermal processing unit (50) and
- a delamination unit (70) which is positioned downstream of the thermal processing unit (50) in the processing direction (X);
wherein the thermal processing unit (50) has a chamber (V) in which there can be received at least one solar panel (10) and is configured to heat a solar panel (10), which is received in the chamber (V), to a processing temperature for a processing time so that the encapsulating element (13) reaches such a softening state as to be delaminable from the operating layer (15).

13. An apparatus (100) according to the preceding claim, wherein the thermal processing unit (50) comprises a heating tunnel (51), preferably with radiant panels.
